# EUROPÄISCHE PATENTSCHRIFT

(11) **EP 0 563 059 B1**
(45) Veröffentlichungstag und Bekanntmachung des Hinweises auf die Patenterteilung: **18.02.1998**
(21) Anmeldenummer: 91920012.1
(22) Anmeldetag: 16.11.1991
(51) Int. Cl.: H01L 27/12

(54) **HOCHSPANNUNGSBAUELEMENT**
HIGH-VOLTAGE CIRCUIT COMPONENT
COMPOSANT A HAUTE TENSION

(30) Priorität: 22.12.1990 DE 4041581; 16.03.1991 DE 4108611
(43) Veröffentlichungstag der Anmeldung: 06.10.1993
(73) Patentinhaber: ROBERT BOSCH GMBH, 70442 Stuttgart (DE)
(72) Erfinder: VOGEL, Manfred, D-7257 Ditzingen Heimerdingen (DE); HERDEN, Werner, D-7016 Gerlingen (DE); DENNER, Volkmar, D-7417 Pfullingen (DE); MINDL, Anton, D-7400 Tübingen (DE)
(86) Internationale Anmeldenummer: DE9100900
(87) Internationale Veröffentlichungsnummer: WO9211659

(56) Entgegenhaltungen:
- FR-A- 1 570 872
- GB-A- 2 011 712
- PATENT ABSTRACTS OF JAPAN vol. 8, no. 213 (E-269)(1650) 28. Juni 1984 & JP,A,59 098 533

## Beschreibung

### Stand der Technik

Die Erfindung geht aus von einem Hochspannungsschalter nach der Gattung des Hauptanspruchs. Aus der FR-A 1570872 ist es bekannt, eine Reihenschaltung von Dioden auf einem Halbleiterchip vorzusehen, wobei hier die einzelnen Verfahrensschritte bei der Herstellung der als Gleichrichter dienenden Diodenschaltung erläutert sind. Aus der EP-A 0 377 619 ist ein Hochspannungsschalter bekannt, der die Funktion eines Zündspannungsverteilers bei ruhender Hochspannungsverteilung übernimmt. Dieser Hochspannungsschalter besteht aus Halbleiterelementen, die in einer Kaskade angeordnet und als Hochspannungstransistoren oder Thyristoren ausgebildet sind, wobei die Kaskade lichtempfindliche Zonen aufweist. Die lichtempfindlichen Zonen können von lichtemittierenden Elementen so angesteuert werden, daß sie zu einem vorgegebenen Zeitpunkt zum Beispiel der Zündfolge entsprechend durchschalten und dadurch die von der Zündspule gelieferten Zündimpulse an die nachgeschaltete Zündkerze anlegen. Bei diesen Kaskadenschaltungen werden 3 bis 50 Fototransistoren oder Fotothyristoren in Reihe geschaltet.

Ebenfalls ein Hochspannungsschalter ist aus der DE-OS 37 31 393 bekannt. Als Hochspannungselemente werden hier Kippdiodenkaskaden verwendet, wobei je nach Spannungsfestigkeit der einzelnen Kippdiode und je nach gewünschter Kippspannung 10 bis 50 Dioden übereinander gestapelt werden. Nachteilig bei diesen bekannten Hochspannungschaltern ist, daß die Kaskadenschaltung in Form von Reihenschaltungen beziehungsweise die Stapelungen relativ viel Platz benötigen.

Aus dem JP-Abstract Nr. 59 098 533 ist ein Einzelthyristorbaulement bekannt, bei dem zur Verkürzung der Ausschaltzeit "Emittershorts" in Form paralleler Streifen angebracht sind und wobei durch Bestrahlung der pn-Übergänge die Schaltspannung herabgesetzt wird.

### Vorteile der Erfindung

Die erfindungsgemäße Anordnung mit den kennzeichnenden Merkmalen des Hauptanspruchs hat demgegenüber den Vorteil, daß nur ein Si-Chip, der dementsprechend mit nebeneinander liegenden Halbleiterelementen strukturiert ist, verwendet wird. Dadurch wird die gesamte Chipfläche gegenüber der Stapeltechnik um ca. 50% reduziert.

Durch die in den Unteransprüchen aufgeführten Maßnahmen sind vorteilhafte Weiterbildungen und Verbesserungen des im Hauptanspruch angegebenen Hochspannungsschalters möglich. Besonders vorteilhaft ist, daß durch das Aufbringen des Si-Wafers auf ein isolierendes Substrat nur mindestens drei freie Seiten vorzugsweise die beiden Längsseiten und die Oberseite mit einem teilweise durchsichtigen Isolator umgeben werden müssen.

Ein weiterer Vorteil ist die laterale homogene Stromverteilung im Wafer. Da der gesamte Wafer in die Strukturierung einbezogen ist und das Licht bei einer Wellenlänge Lambda von etwa 900 nm ca. 100 µm eindringen kann, was etwa der gesamten Tiefe des Wafers entspricht, können Ladungsträger in der gesamten Tiefe des Wafers erzeugt werden.

### Zeichnung

Ausführungsbeispiele der Erfindung sind in der Zeichnung dargestellt und in der nachfolgenden Beschreibung näher erläutert. Es zeigt Figur 1 den Prinzipaufbau einer Kippdiodenkaskade als Single-chip, Figur 2 zeigt die Draufsicht auf den Single-chip und Figur 3 zeigt die Kaskadierung von Kippdioden mit symmetrischer Kennlinie (Fünfschichtdiode) auf einem Single-chip.

### Beschreibung der Ausführungsbeispiele

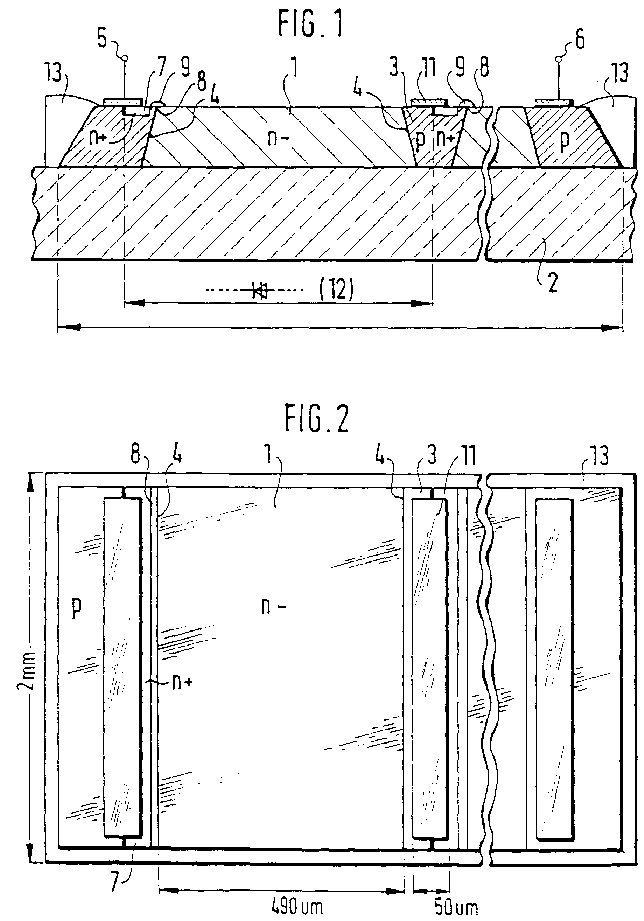

Figur 1 zeigt im Querschnitt den prinzipiellen Aufbau einer Kippdiodenkaskade als Single-chip in Planartechnik. Die planare Kippdiodenkaskade besteht aus einem ca. 50 bis 200 Mikrometer dicken monokristallinen Halbleiterträger, insbesondere ein Siliziumwafer 1, welcher n-dotiert ist und an seiner Unterseite auf ein isolierendes Substrat 2, beispielsweise Glas, Keramik, Saphir oder ähnliches, aufgebracht ist. In dieser Siliziumscheibe befinden sich mehrere p-dotierte Gebiete 3, die durch das n-Silizium hindurch, bis an dessen Unterseite an das isolierende Substrat 2 reichen, so daß pn-Übergänge 4 entstehen. Die p-Dotierungen sind streifenförmig in einem Abstand von z. B. 490 Mikrometern über die gesamte Breite des Single-chip quer zur Strecke von Anschlußkontakt 5 bis Anschlußkontakt 6 verteilt und haben eine Breite von z. B. 110 Mikrometern. Bei der Strukturierung des Siliziumwafers 1 mittels p-Diffusionen muß darauf geachtet werden, daß kein durchgehender ohmscher Pfad entsteht, um die Isolation an der Unterseite des Wafers mittels der Isolationsschicht 2 zu gewährleisten. Das heißt, es muß darauf geachtet werden, daß die p-Diffusion wirklich bis an die Unterseite des Wafers erfolgt. Aus diesem Grund verwendet man vorzugsweise einen ca. 100 µm dünnen Wafer. In die p-Gebiete 3 des Siliziumwafers 1 sind streifenförmige n⁺-Gebiete 7 hineindiffundiert, wobei die Streifen 7 auch unterbrochen sein können. Die Breite dieser Streifen beträgt z. B. 50 µm und die Länge entspricht der Breite des Single-chip, welche z. B. 2 mm beträgt. Am Anschlußkontakt 6 ist die Diffusion mit n+ in das p-Gebiet 3 nicht notwendig, da eine Einzelkippdiode 12 sich aus vier Schichten zusammensetzt. Diese vier Schichten bestehen aus n+, p, n-, p. Die Kaskadierung wird an der Abbruchkante des Siliziumwafers 1 beendet, so daß kein neues n+ für eine nächste Einzelkippdiode benötigt wird. An den Randbereichen der so gebildeten Kippdiodenkaskade werden die p-Gebiete 3 mit einer Isolierschicht 13 überzogen, die von der Oberseite des Siliziumwafers 1 über den Randbereich bis auf das isolierende Substrat 2 reicht. Die pn-übergänge 4 werden an der Oberseite der Siliziumscheibe so ausgebildet, daß fotoempfindliche Fenster 8 entstehen, das heißt die Isolierung der pn-Übergänge nach außen erfolgt mittels Oxid- oder Glaspassivierung 9. Zusätzlich ist es möglich, zur Erhöhung des Lichteinfalls die pn-Übergänge, insbesondere an den Längsseiten, zunächst mit einer Grabenätzung zu versehen und anschließend die Isolierung mit einem entsprechend durchsichtigen Isoliermittel 13 vorzunehmen. Die Schichtdicke der Isolationsschicht kann hierbei so festgelegt werden, daß sie an die Lichtempfindlichkeit einer bestimmten Wellenlänge des einfallenden Lichts angepaßt ist. Auf die Oberseite werden letztendlich Metallisierungen 11 streifen- oder punktförmig aufgebracht, um an den einander gegenüberliegenden Endbereichen des Single-Chips entsprechende Anschlüsse 5 und 6 anzubringen. In dieser planaren Kippdiodenkaskade erfolgt ein lateraler Stromfluß, wobei die Sperrspannung der Kaskade durch die Sperrspannung der symbolisch angedeuteten Einzelkippdioden 12 und durch deren Anzahl festgelegt wird. Durch die Bestrahlung der pn-Übergänge werden Ladungsträger in der gesamten Tiefe der Siliziumscheibe erzeugt, wobei es zu einem homogenen Stromfluß kommt und die Durchbruchspannung herabgesetzt wird.

Figur 2 zeigt die Draufsicht des Single-chip analog der Figur 1. Bei der Draufsicht wurde auf die Darstellung der Glaspassivierung verzichtet, um die streifenförmigen Dotierungen besser zu verdeutlichen. Hier ist deutlich zu erkennen, daß die p-Gebiete 3 streifenförmig über den gesamten Single-Chip in den n-dotierten Silizium Einkristall 1 strukturiert sind, und daß die n⁺-Gebiete 7 ebenfalls streifenförmig über den gesamten Single-Chip verteilt sind, wobei diese n⁺-Gebiete eine geringere Eindringtiefe haben. Auf die strukturierte Silizumscheibe werden im Bereich der n⁺-Diffusionen Metallisierungen, die die Grundlage für die Verbindung mit den Anschlußkontakten 5 und 6 bilden, aufgebracht.

Die Metallisierungen 11 schließen dabei die n⁺-Gebiete 7 mit dem darunter liegenden p-Gebiet 3 kurz. Der so entstehende Unterdurchwiderstand (pinch-Widerstand unter dem n⁺-Gebiet 7) bestimmt die Kippbedingungen des Kippdiodenelements.

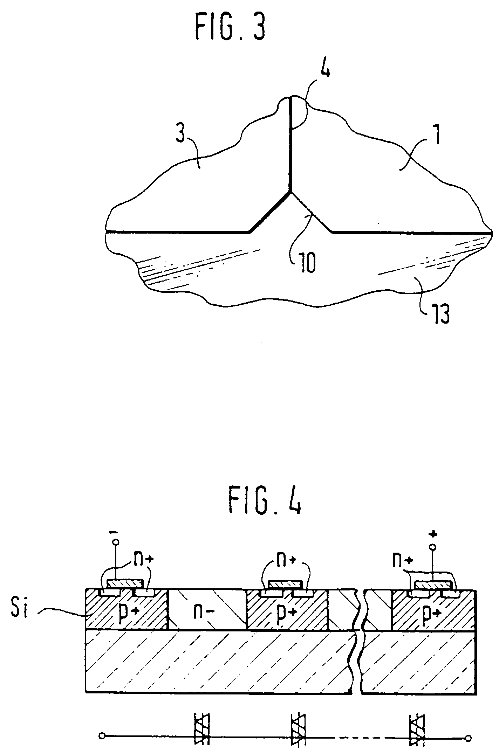

Figur 3 zeigt einen Ausschnitt der Figur 2, wobei hier die Bildung der pn-Übergänge an den Längsseiten des Single-Chip dargestellt ist. Die pn-Übergänge können mittels Grabenätzung freigelegt werden, so daß kleine Wannen 10 entstehen. Diese Wannen werden anschließend mit dem durchsichtigen Isoliermittel 13 ausgefüllt, so daß die Längsseiten zur Verstärkung des Effekts der Ladungsträgererzeugung durch Lichtbestrahlung herangezogen werden können.

Figur 4 verdeutlicht, daß die Strukturierung eines monokristallinen n-dotierten Siliziumeinkristalls auch die Bildung von Kaskaden anderer Bauelemente zum Beispiel Kippdioden mit symmetrischer Kennlinie, sogenannte bipolaren Kippdioden, ermöglicht. Zusätzlich wird in dieser Figur symbolhaft die Kaskadierung durch Schaltsymbole dargestellt.

Für die Bildung der pn-Übergänge ist es auch möglich, einen p-dotierten monokristallinen Siliziumchip zu verwenden, der seinerseits mit n-Dotierungen und den darin eingelagerten p-Dotierungen streifenförmig versehen wird. Bei einer solchen Strukturierung ist es lediglich von Bedeutung, Leitfähigkeitstypen entgegengesetzter Art zu verwenden.

## Patentansprüche

1. Reihenschaltung von Hochspannungshalbleiterelementen, die durch die Strukturierung eines auf einem isolierenden Substrat aufgebrachten Siliziumwafers gebildet ist, welcher einen ersten Leitungstyp aufweist und mindestens zwei an gegenüberliegenden Seiten angebrachte Anschlußkontakte aufweist, sowie mit mehreren, sich streifenförmig quer zur Strecke zwischen den Anschlußkontakten erstreckenden Gebiete eines zweiten entgegengesetzten Leitungstyps, wobei diese Gebiete mit einem Abstand untereinander sich über die gesamte Breite des Siliziumwafers erstrecken und die gesamte Dicke des Siliziumwafers durchdringen, dadurch gekennzeichnet, daß in den Gebieten des zweiten Leitungstyps (3) streifen- oder punktförmig flache Gebiete des ersten Leitungstyps (7) eingebracht sind, die an die Oberfläche des Siliziumwafers reichen, so daß die Reihenschaltung von Vierschichtbauelementen entsteht und daß bei Lichtbestrahlung der Übergänge von einem Leitungstyp zum entgegengesetzten Leitungstyp die Schaltspannung der Reihenschaltung herabsetzbar ist.

2. Reihenschaltung nach Anspruch 1, dadurch gekennzeichnet, daß der erste Leitungstyp (1) ein n-dotiertes Gebiet ist und der zweite entgegengesetzte Leitungstyp (3) ein p-dotiertes Gebiet ist.

3. Reihenschaltung nach Anspruch 2, dadurch gekennzeichnet, daß in die p-Gebiete (3) n+-Dotierungen (7) streifen- oder punktförmig eingebracht sind.

4. Reihenschaltung nach Anspruch 3, dadurch gekennzeichnet, daß auf den Siliziumwafer Metallisierungen (11) streifenförmig aufgebracht sind, die die p- und n+-Gebiete (3 und 7) teilweise überdecken und für die Anschlußkontakte (5, 6) verwendbar sind.

5. Reihenschaltung nach einem der vorherigen Ansprüche, dadurch gekennzeichnet, daß der Siliziumwafer (1) eine Dicke von 50 bis 200 µm hat.

6. Reihenschaltung nach einem der vorherigen Ansprüche, dadurch gekennzeichnet, daß die Übergänge (4) von einem Leitungstyp zum entgegengesetzten Leitungstyp mindestens an den beiden Längsseiten des Siliziumwafer durch eine Grabenätzung freigelegt und mit Isoliermaterial (23) abgedeckt sind.

7. Reihenschaltung nach einem der vorherigen Ansprüche, dadurch gekennzeichnet, daß die Übergänge (4) von einem Leitungstyp zum entgegengesetzten Leitungstyp zur Isolation mit einer lichtdurchlässigen Glas oder Oxidpassivierung (9) oder einem Isoliermittel (13) überzogen sind.

## Claims

1. Series circuit of high-voltage semiconductor elements which is formed by the structuring of a silicon wafer which is applied to an insulating substrate, has a first conductivity type and has at least two terminals provided on opposite sides, as well as having a plurality of areas, extending in a strip-like fashion at right angles to the areas between the terminals, of a second, opposite conductivity type, these areas extending at a distance from one another over the entire width of the silicon wafer and penetrating the entire thickness of the silicon wafer, characterised in that flat areas of the first conductivity type (7) are incorporated, in a strip-like or point-like fashion, in the areas of the second conductivity type (3), which flat areas extend to the surface of the silicon wafer, in such a way as to produce the series circuit of four-layer components, and in that, when the junctions from one conductivity type to the opposite conductivity type are irradiated with light, the switching voltage of the series circuit can be reduced.

2. Series circuit according to Claim 1, characterised in that the first conductivity type (1) is an n-doped area and the second, opposite conductivity type (3) is a p-doped area.

3. Series circuit according to Claim 2, characterised in that n⁺ dopings (7) are incorporated in a strip-like or point-like fashion into the p-areas (3).

4. Series circuit according to Claim 3, characterised in that metallic coatings (11) which partially cover the p⁻ and n⁺ areas (3 and 7) and can be used for the terminals (5, 6) are applied in a strip-like fashion to the silicon wafer.

5. Series circuit according to one of the preceding claims, characterised in that the silicon wafer (1) has a thickness of 50 to 200 µm.

6. Series circuit according to one of the preceding claims, characterised in that the junctions (4) from one conductivity type to the opposite conductivity type are exposed by a trench etching at least on the two longitudinal sides of the silicon wafer, and are covered by an insulating material (23).

7. Series circuit according to one of the preceding claims, characterised in that the junctions (4) from one conductivity type to the opposite conductivity type are coated for the purpose of insulation with a light-transmitting glass or oxide passivation (9) or an insulant (13).

## Revendications

1. Montage en série d'éléments semi-conducteurs de haute tension, formé par la mise en structure d'une puce de silicium montée sur un support isolant, qui présente un premier type de conductivité et comporte au moins deux contacts de branchement prévus sur les côtés opposés, ainsi que plusieurs zones s'étendant en forme de bandes transversalement au chemin entre les contacts de branchement et ayant un second type de conductivité, ces zones s'étendant avec un intervalle entre elles sur toute la largeur de la puce de silicium et traversant toute l'épaisseur de la puce de silicium,
caractérisé en ce que
dans les zones du second type de conductivité (3), on a réalisé des zones plates en forme de bandes ou de points correspondant au premier type de conductivité (7), et qui arrivent jusqu'à la surface de la puce de silicium pour obtenir un branchement en série de composants à quatre couches et, sous l'effet de l'irradiation par la lumière, les jonctions d'un premier type de conductivité vers le type de conductivité opposé, réduisent la tension de commutation du montage en série.

2. Montage en série selon la revendication 1,
caractérisé en ce que
le premier type de conductivité (1) est une zone à dopage n et le second type de conductivité (3), opposé, est une zone à dopage p.

3. Montage en série selon la revendication 2,
caractérisé en ce que
dans les zones (3) à dopage p on a réalisé des dopages (7) de type n⁺ sous la forme de bandes ou de points.

4. Montage en série selon la revendication 3,
caractérisé en ce que
sur la puce de silicium on a appliqué des métallisations (11) sous forme de bandes qui chevauchent partiellement les zones de type p et n⁺ (3 et 7) et servent aux contacts de branchement (5, 6).

5. Montage en série selon l'une des revendications précédentes,
caractérisé en ce que
la puce de silicium (1) a une épaisseur comprise entre 50 et 200 µm.

6. Montage en série selon l'une des revendications précédentes,
caractérisé en ce que
les jonctions (4) d'un type de conductivité sont dégagées par rapport au type de conductivité opposé, au moins au niveau des deux grands côtés de la plaquette de silicium, par un sillon réalisé par attaque chimique et recouvert d'une matière isolante (23).

7. Montage en série selon l'une des revendications précédentes,
caractérisé en ce que
les jonctions (4) d'un type de conductivité vers le type de conductivité opposé et vers l'isolant, sont revêtues d'un verre transparent à la lumière ou d'une passivation par oxyde (9) ou d'un agent isolant (13).
